Europäisches Patentamt

European Patent Office

Office européen des brevets

(11) Publication number: **0 113 983**
**B1**

# EUROPEAN PATENT SPECIFICATION

(45) Date of publication of patent specification: **22.04.87**

(21) Application number: **83307679.7**

(22) Date of filing: **16.12.83**

(51) Int. Cl.⁴: **H 01 L 21/203**, H 01 J 37/30, C 30 B 23/02

(54) Fabricating a semiconductor device by means of molecular beam epitaxy.

(30) Priority: **28.12.82 JP 229708/82**
**16.12.82 JP 220663/82**

(43) Date of publication of application:
**25.07.84 Bulletin 84/30**

(45) Publication of the grant of the patent:
**22.04.87 Bulletin 87/17**

(84) Designated Contracting States:
**DE FR GB**

(56) References cited:
**EP-A-0 055 032**
**EP-A-0 056 737**
**EP-A-0 060 151**
**FR-A-2 391 769**
**GB-A-1 528 192**

**IEEE SPECTRUM, vol. 17, no. 4, April 1980, New York G. PANISH et al. "Molecular beam epitaxy", pages 18-23**

**APPLIED PHYSICS LETTERS vol. 39, no. 3, August 1981, New York C. CHANG et al. "Effect of substrate surface treatment in molecular beam epitaxy on the vertical electronic transport through the film-substrate interface", pages 229-231**

(73) Proprietor: **FUJITSU LIMITED**
**1015, Kamikodanaka Nakahara-ku Kawasaki-shi Kanagawa 211 (JP)**

(72) Inventor: **Mimura, Takashi**
**1-10-42, Higashitamagawagakuen Machida-shi Tokyo 194 (JP)**
Inventor: **Hikosaka, Kohki**
**Takefuji-so 205,59-2 Shiratoridai Midori-ku Yokohama-shi Kanagawa 227 (JP)**
Inventor: **Odani, Kouichiro**
**1-408, 5, Araisono 4-chome Sagamihara-shi Kanagawa 228 (JP)**
Inventor: **Ishikawa, Tomonori**
**2-9-44, Sakae-cho Odawara-shi Kanagawa 250 (JP)**
Inventor: **Nishi, Hidetoshi**
**1-22-10, Chuorinkan Yamato-shi Kanagawa 242 (JP)**

(74) Representative: **Fane, Christopher Robin King et al**
**HASELTINE LAKE & CO. Hazlitt House 28 Southampton Buildings Chancery Lane London, WC2A 1AT (GB)**

## Description

The present invention relates to fabricating a semiconductor device by means of molecular beam epitaxy (MBE).

In the fabrication of semiconductor devices, and in particular compound semiconductor devices, semiconductor layers with different widths of forbidden bands, conduction types, or carrier concentrations are often epitaxially grown on a semiconductor substrate to form a multilayer structure. This epitaxial growth may be effected by MBE, liquid phase epitaxy, vapor phase epitaxy, including organic-metal-pyrolysis vapor phase epitaxy, etc.

MBE allows precise control of the composition, the amount of doped impurity, and the growth rate of the semiconductor crystal layer, sharp change of the profile of the composition of a crystal layer or the amount of a doped impurity, for example, a width of change of approximately 1 nm, and growth of a crystal layer with a composition different from one obtained in the state of chemical equilibrium, not possible with liquid phase epitaxy. MBE is therefore a preferred technique for forming a semiconductor crystal multilayer structure with extremely thin layers and very sharp changes of composition at the interfaces of the layers, as in a superlattice device.

The surface of a substrate on which a crystal layer is to be formed by MBE should be kept clean to enable full use of the above-mentioned features of MBE. When the substrate is a crystal layer of gallium arsenide (GaAs), the substrate can be heated in advance to remove the oxide layer formed on the surface of the GaAs layer due to exposure to the atmosphere. However, when the substrate is aluminum gallium arsenide (AlGaAs), for example, the surface oxide layer formed on the surface of the substrate is aluminum oxide ($Al_2O_3$), a stable oxide difficult to remove by heat treatment.

If MBE is effected onto an AlGaAs single crystal substrate without cleaning the surface thereof, an amorphous layer will be formed on the substrate. In the case of a GaAs single crystal layer and an AlGaAs single crystal layer superposed thereon with an opening exposing the surface of the GaAs layer, MBE will not form a single crystal layer fully in the opening since an amorphous layer is formed from the surface of the AlGaAs wall since the surface oxide layer of the AlGaAs layer could not be removed.

Such a thermally stable surface oxide layer may be removed by milling by, for example, argon (Ar) ions. This, however, constitutes physical etching, which can damage the surface of the crystal substrate, and therefore should not be used when fabricating, for example, a heterojunction-type field effect transistor (FET). In place of physical etching, use of dry chemical etching may be considered to remove the thermally stable surface oxide layer. Such etching, however, requires use of an etchant gas including chlorine (Cl), fluorine (F), carbon (C), or the like. Such a gas may damage an extremely high vacuum pump, such as an ion pump or a cryo pump, resulting in decreased power of evacuation after, for example, three months daily use, an extremely high vacuum being essential for MBE. It may also contaminate an MBE apparatus, resulting in corrosion. Therefore, in practice, dry chemical etching with these gases is not entirely suitable for use in combination with MBE.

It is known that a semiconductor, for example, GaAs, can be etched by hydrogen plasma (R. P. H. Chang, C. C. Chang and S. Darack "Hydrogen plasma etching of semiconductors and their oxides" J. Vac. Soc. Technol., 20(1), Jan. 1982, pp 45-50).

According to the present invention, a method of manufacturing a semiconductor device comprises the steps of subjecting a part of a semiconductor substrate to a hydrogen plasma etching process and then forming a semiconductor layer on the substrate in a vacuum by a molecular beam epitaxy process, the substrate being maintained under vacuum without any break thereof between the etching and epitaxy processes.

It is found that hydrogen gas does not damage an extremely high vacuum pump nor deteriorate a GaAs, AlGaAs, or other semiconductor layer formed by MBE and that hydrogen plasma can etch an AlGaAs or other thermally stable semiconductor layer.

The hydrogen plasma etching may be used not only for cleaning the surface of a semiconductor substrate formed by MBE but also for selectively etching a semiconductor substrate to form an opening, a cavity, etc., before forming a semiconductor layer by MBE.

Problems also exist in the condition of the surface of a layer formed by MBE. In the conventional process for fabricating a semiconductor device, after the MBE is effected, the substrate and the crystal layer formed thereon by the MBE are cooled and then discharged from the MBE apparatus into the atmosphere before forming the semiconductor elements in and on the MBE layer.

In such a prior process, heat treatment after MBE may affect adversely the properties of an active region in MBE layers near the top surface. Such deterioration results from diffusion of an impurity into the active region. It is desirable to prevent this to maintain the excellent properties of the MBE layers.

For example, MBE is often used for the fabrication of heterojunction FET's. Here, MBE is used to form a nondoped GaAs layer and then a silicon-doped AlGaAs layer on a semi-insulating GaAs substrate. The interface of the GaAs layer and the AlGaAs layer is a heterojunction. An electron accumulating layer (two dimensional electron gas) is formed by displacement of electrons from the n-type AlGaAs layer (an electron supply layer) to the nondoped GaAs layer. If the electron sheet concentration of the electron storage layer is controlled by a voltage applied to a gate electrode formed on the n-type AlGaAs layer, the im-

pedance of the conducting channel in the electron storage layer between a source electrode and a drain electrode is controlled. As a result, the device functions as a transistor.

To form ohmic contact regions of the source and drain electrodes of such a heterojunction-type FET, the following steps are often taken: selectively implanting silicon ions into multiple n-type AlGaAs and nondoped GaAs layers; forming a surface protective layer on the n-type AlGaAs layer; and heating at 700°C to 800°C to activate the ion-implanted regions. This type of heat treatment lowers the electron mobility, however, for example, from approximately 110,000 cm$^2$/V·sec immediately after MBE to approximately 70,000 cm$^2$/V·sec after heat treatment at 700°C for 15 minutes. The lowering of the electron mobility results from diffusion of silicon (Si) ions from the n-type AlGaAs layer into the nondoped GaAs layer. This lowering of the electron mobility by heat diffusion of an impurity is an important problem in that it negates the effect of providing a heterojunction interface for three dimensionally separating an impurity-doped layer for generating carriers and a channel layer.

It is desirable to prevent diffusion of impurities in a semiconductor layer formed by MBE.

The inventors have discovered that forming a protective layer such as an AlN layer on the surface of a crystal layer formed by MBE in the vacuum used in MBE prevents formation of an oxide layer at the surface of the MBE crystal layer due to exposure of the MBE layer to the atmosphere and dissociation of a component atom of the MBE crystal layer and formation of holes and other defects in the crystal during heat treatment of the MBE layer, which can prevent or decrease diffusion of an impurity in the MBE crystal layer. The inventors found that the lowering of the electron mobility of a heterojunction-type FET is greatly accelerated by a surface oxide layer of the MBE layer formed between MBE and formation of a protective layer for heat treatment in the prior art, and, therefore, deterioration of electrical properties such as lowering of the electron mobility is greatly decreased by preventing formation of a surface oxide layer of the MBE layer due to prevention of diffusion of an impurity. According to a further aspect of the invention, a surface protective layer is formed without breaking vacuum used in MBE.

This process is preferably carried out by subjecting a semiconductor substrate to a vacuum and then transporting it to successive stations where it is subjected under vacuum to a hydrogen plasma etch process, to a molecular beam epitaxy process to form a semiconductor layer on the substrate, and then to a process which causes a protective layer to be formed on the semiconductor layer, all without breaking the vacuum.

The invention also includes apparatus for use in manufacturing a semiconductor device, comprising

a first vacuum chamber containing means whereby a semiconductor substrate can be subjected to a hydrogen plasma etching process;

a second vacuum chamber containing means whereby such substrate can be subjected to a molecular beam epitaxy process to form a semiconductor layer on such substrate;

vacuum pump means for establishing a vacuum in each vacuum chamber; and

transfer means defining a vacuum-tight passageway, between the two vacuum chambers, and including conveying apparatus, whereby such semiconductor substrate can be moved from the said first vacuum chamber to the said second vacuum chamber whilst being maintained continuously under vacuum. The apparatus may also comprise a third vacuum chamber containing means whereby the substrate can be subjected to a process for forming a protective layer on the semiconductor layer formed by the epitaxy process. In this apparatus a vacuum pump means is arranged to establish a vacuum in each vacuum chamber and the transfer means defines a vacuum-tight passageway between the three vacuum chambers and includes carrying apparatus whereby the semiconductor substrate can be moved between the vacuum chambers whilst being maintained continuously under vacuum.

Reference will now be made, by way of example, to the accompanying drawings, in which:

Fig. 1 is a schematic view of apparatus for fabricating a semiconductor device, embodying the present invention;

Fig. 2 is a perspective view of a wafer attached to a molybdenum (Mo) block;

Figs. 3a to 3f are sectional views of an FET in the steps of fabrication;

Fig. 4 is a sectional view of a test-purpose FET manufactured by a method embodying the present invention;

Figs. 5a and 5b are graphs of I/V characteristics of FET's in the making of which H$_2$ plasma etching and Ar milling or etching are used, respectively;

Figs. 6a to 6e are sectional views of an FET in the steps of fabrication;

Fig. 7 is a graph of electron mobility against time of heat treatment;

Fig. 8 is a graph of electron mobility against temperature of heat treatment; and

Fig. 9 is a graph of concentration of electrons in an electron storage layer.

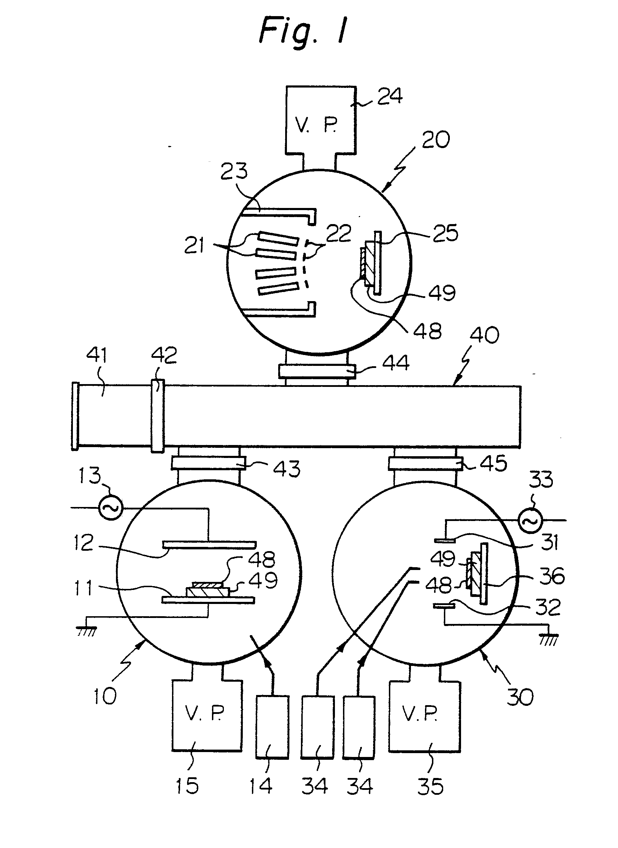

Figure 1 schematically illustrates apparatus for fabricating a semiconductor device embodying the present invention. The apparatus comprises three chambers 10, 20, and 30 for H$_2$ plasma etching, for MBE, and for forming a protective layer, usually an insulating layer, respectively.

The H$_2$ plasma etching chamber 10 comprises parallel plate-shaped electrodes 11 and 12 connected to a high frequency power source 13. An H$_2$ gas source 14 and a vacuum pump 15 are connected to the chamber 10.

The MBE chamber 20 comprises cells 21 of molecular beam sources. A shutter 22 is provided for each cell 21 to allow selection of the required molecular beam source. The cells 21 are surrounded by a shroud 23 cooled by liquid nitrogen. An extremely high vacuum pump 24 such as an ion pump or a cryo pump is connected to the MBE chamber 20.

The chamber 30 for forming an insulating layer is, in this case, a sputtering chamber. Alternatively, it may be a chemical vapor deposition (CVD) chamber. The sputtering chamber comprises electrodes 31 and 32 connected to a high frequency power source 33, a target (not shown in the figure) being set on one of the electrodes 31 and 32. Gas sources 34 and a vacuum pump 35 are connected to the sputtering chamber 30.

The three chambers 10, 20 and 30 are closed to maintain the vacuum and are communicated with each other through a section 40, the section 40 comprising a wafer-transporting mechanism also closed to maintain the vacuum. The wafer-transporting section 40 has a chamber 41 for mounting and removing wafers. A valve 42 is provided between the chamber 41 and a main chamber of the wafer-transporting section 40. Valves 43, 44 and 45 are provided between the wafer-transporting section 40 and the $H_2$ plasma etching chamber 10, the MBE chamber 20, and the sputtering chamber 30, respectively. Thus, a wafer 48 to be treated can be transported between the $H_2$ plasma etching chamber 10, the MBE chamber 20, and the sputtering chamber 30 respectively without breaking the vacuum state.

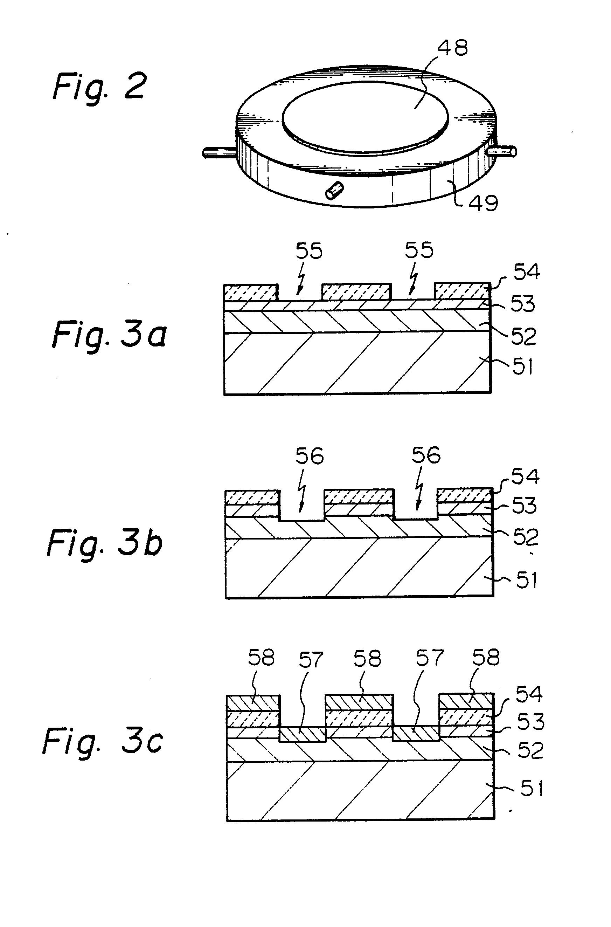

Referring to Fig. 2, a wafer 48 to be treated is bonded onto an Mo block 49. This Mo block 49 is mounted on the wafer-transporting mechanism, transported to each chamber 10, 20 or 30, and held on the electrode 11 or by a holder 25 or 36. The three chambers 10, 20, and 30 can be closed individually. Individual vacuum pumps 15, 24, and 35 do not necessarily have to be used, i.e., a single vacuum pump or two vacuum pumps may be used in place of the three vacuum pumps.

It will be understood that an embodiment of the present invention may incorporate any conventional $H_2$ plasma etching chamber, MBE chamber, insulating-layer formation chamber, and wafer-transporting means and that the apparatus is therefore not limited to that described above. Further, an embodiment of the present invention may involve only $H_2$ plasma etching and MBE and no formation of an insulating layer.

Below, an explanation will be given of a method of fabrication of a heterojunction-type FET, embodying the present invention.

Referring to Fig. 3a, a nondoped GaAs layer 52 of, e.g., 600 nm and an n-type AlGaAs layer 53 of, e.g., 100 nm are continuously formed by MBE on a semi-insulating GaAs substrate 51. The n-type AlGaAs layer 53 is Si-doped at a dosage of, e.g., $1 \times 10^{18} cm^{-3}$. A silicon dioxide (SiO$_2$) layer 54 of, e.g., 300 nm thickness is deposited onto the n-type AlGaAs layer 53 by a reactive sputtering process and selectively etched by a photolithography process to form windows 55 where source and drain regions are to be formed.

Referring to Fig. 3b, selective etching is conducted by using the $SiO_2$ layer 54 as a mask to form cavities 56 passing through the n-type AlGaAs layer 53 and a part of the nondoped GaAs layer 54, e.g., 300 nm thick. The wafer is then taken out of the etching chamber, resulting in contact with the atmosphere and, therefore, spontaneous formation of an oxide layer on the surface of the n-type AlGaAs layer 53 and the nondoped GaAs layer 54 in the cavity.

Referring to Figs. 1 and 3b, the wafer having the cavities 56 is then mounted in the wafer-transporting mechanism in the section 40, transported to the $H_2$ plasma-etching chamber 10, and fixed onto the electrode 11. The valve 43 is closed. The three chambers 10, 20, and 30 are evacuated by the vacuum pumps 15, 24, and 35. Hydrogen gas is fed to the $H_2$ plasma etching chamber 10 through a valve (not shown), the pressure in the chamber 10 being approximately $10^{-3}$ Torr. A high frequency power of 100 V, 13.56 MHz is applied to generate $H_2$ plasma in the chamber 10 so that the exposed surfaces of the n-type AlGaAs layer 53 and the nondoped GaAs layer 52 in the cavities 56 are etched with the $SiO_2$ layer 54 acting as a mask. This etching completely removes the oxide layer at the surface in the cavities 56. The etching rate of $H_2$ plasma etching is not so high, but it is sufficient for use in practice.

After the $H_2$ supply is stopped, the chamber 10 is evacuated again to a vacuum of approximately $10^{-7}$ to $10^{-8}$ Torr and the valves 43 and 44 are opened so as to transport the wafer 48 into the MBE chamber 20. The wafer 48 is fixed to the holder 25 and the valve 44 is closed.

Referring to Fig 1 and Fig. 3c, MBE is conducted to form source and drain regions 57 of n$^+$-type GaAs. In the MBE chamber 20 of, e.g., $10^{-10}$ Torr, Ga, As, and Si molecular beams are applied from three cells 21 onto the wafer, while controlling the temperature in the chamber 20 and of the cells 21 and the wafer 48. Selectively, source gases may be supplied into the MBE chamber 20 from gas sources through pipes having valves (gas source, pipes, and valves not shown in figures). The dosage of Si in the n$^+$-type GaAs source and drain region 57 is $1 \times 10^{18} cm^{-3}$ to $2 \times 10^{18} cm^{-3}$. Electron beam diffraction analysis confirms that the resultant n$^+$-type GaAs source and drain region 57 are of complete single crystal and that an n$^+$-type amorphous layer 58 is formed on the surface of the SiO$_2$ layer 54.

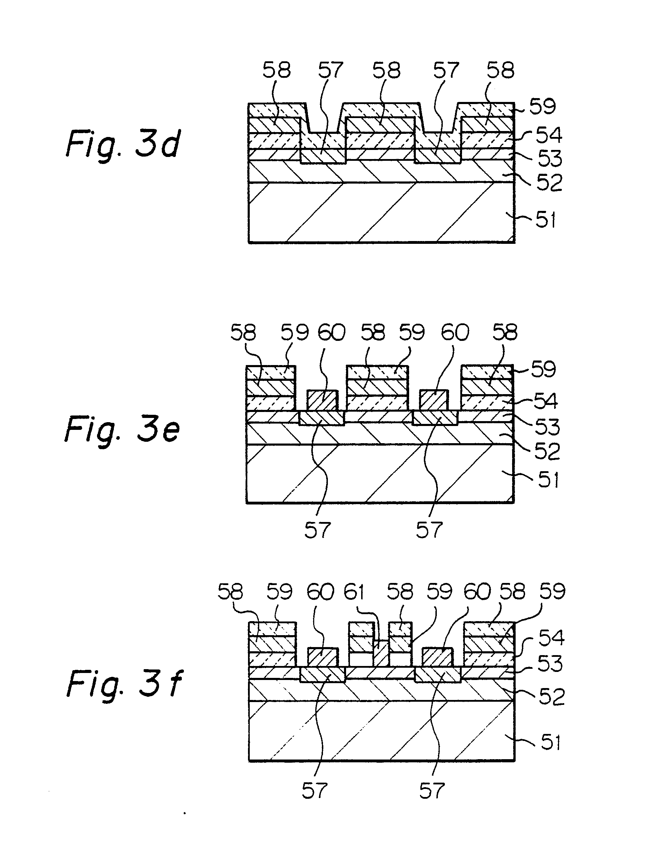

Referring to Fig. 1 and Fig. 3d, the MBE chamber 20 is evacuated again to clean it. The valve 44 is opened and the wafer 48 is transported to the insulating-layer formation chamber 30 in which the wafer 48 is fixed to the holder 36. The valve 45 is closed. An insulating layer 59 of silicon nitride ($Si_3N_4$) is formed on the entire surface as a protective layer. For example, a target of silicon is placed in the chamber 30 and nitrogen ($N_2$) gas is fed to the chamber 30 from a gas source 34. A high frequency of, e.g., 13.56 MHz is applied at

$10^{-3}$ Torr so that Ar ions are accelerated to sputter the target, depositing an $Si_3N_4$ layer on the wafer 48.

The wafer 48 is then taken out of the apparatus in Fig. 1. Referring to Fig. 3e, source- and drain-electrode contact windows are opened, then source and drain electrodes 60 are formed by depositing and then patterning gold-germanium/gold (Au·Ge/Au) layers.

Referring to Fig. 3f, a gate-electrode contact window is opened, then a gate electrode is formed by depositing and then patterning a Schottky electrode metal layer such as aluminum (Al) or titanium/platinum/gold (Ti/Pt/Au). These processes for forming electrodes 60 and 61 are conventional.

While the above explanation has the cavities 56 formed by a separate etching apparatus, they may be formed by $H_2$ plasma etching in the chamber 10 of the apparatus in Fig. 1. In such a case, after etching, the wafer 48 can be transported directly to the MBE chamber 20 to form source and drain regions 57 by MBE, since no surface oxide layer is formed.

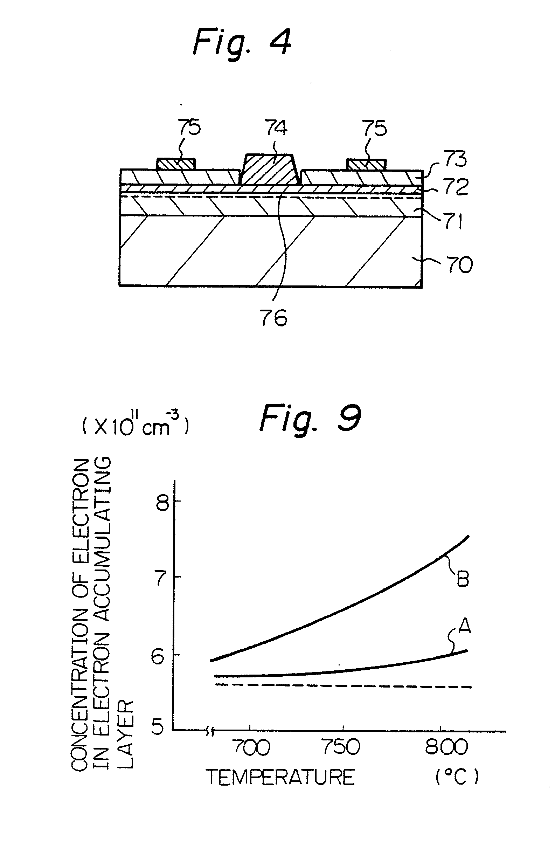

The advantage of $H_2$ plasma etching over Ar milling or etching can be seen from an experiment of fabricating a heterojunction-type FET as in Fig. 4. This FET is fabricated by continuously growing on a semi-insulating GaAs layer 70 a nondoped GaAs layer 71 of 600 nm thickness, an n-type AlGaAs layer 72 of $1 \times 10^{18}$cm$^{-3}$ to $2 \times 10^{18}$cm$^{-3}$-Si dosage and 30 to 50 nm thickness, and an AlGaAs cap layer 73 of $1 \times 10^{18}$cm$^{-3}$ to $2 \times 10^{18}$cm$^{-3}$-Si dosage and 100 nm thickness by MBE. A gate electrode 74 is formed by selectively etching or milling the cap layer 73 in a depth of approximately 100 nm, depositing Al or Ti/Pt/Au layers, and patterning them. Source and drain electrode 75 are formed by depositing Au·Ge/Au layers and patterning them.

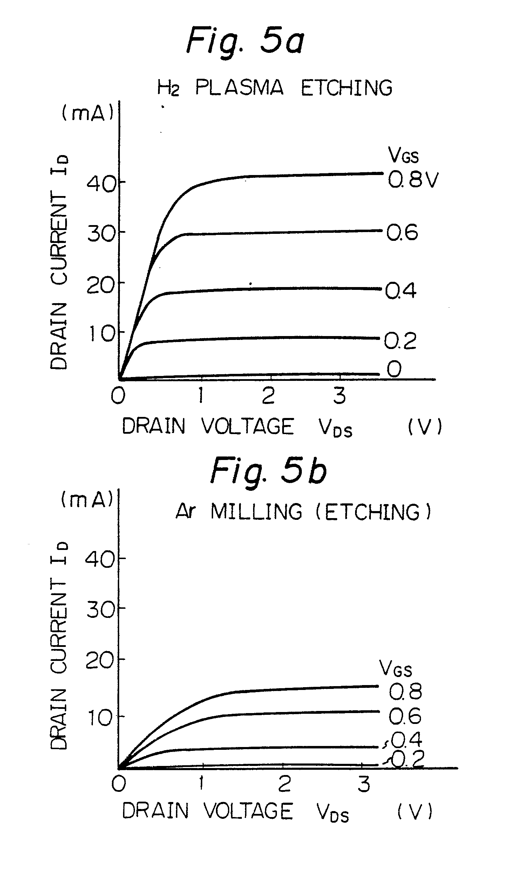

The etching or milling process is conducted by $H_2$ plasma etching or by Ar milling or etching, respectively. $H_2$ plasma etching is conducted in an parallel-plate-type etching apparatus at $10^{-3}$ Torr, 13.56 MHz, 100 V (50 W), and 10 nm/min. Ar milling or etching is conducted in an ion-milling-type etching apparatus at $10^{-3}$ Torr, 500 V, and 100 nm/min. The $I_D/V_{DS}$ (drain current/drain voltage) characteristics at different $V_{GS}$'s (gate voltage) of the thus obtained FET's are summarized in Figs. 5a and 5b. As can be seen from Figs. 5a and 5b, $H_2$ plasma etching greatly improved the $I_D/I_{VS}$ characteristics of the FET. This is because $H_2$ plasma etching does not damage the active layer of the FET, i.e., the channel region 76 existing in the nondoped GaAs layer 71 near the interface to the n-type AlGaAs layer 72.

Below, an explanation will be given of the fabrication of a heterojunction-type FET wherein the source and drain contact regions are formed by ion implantation. In this case, the problem of cleaning is not considered. Only the problem of the condition of the surface of the semiconductor layer formed by MBE is considered.

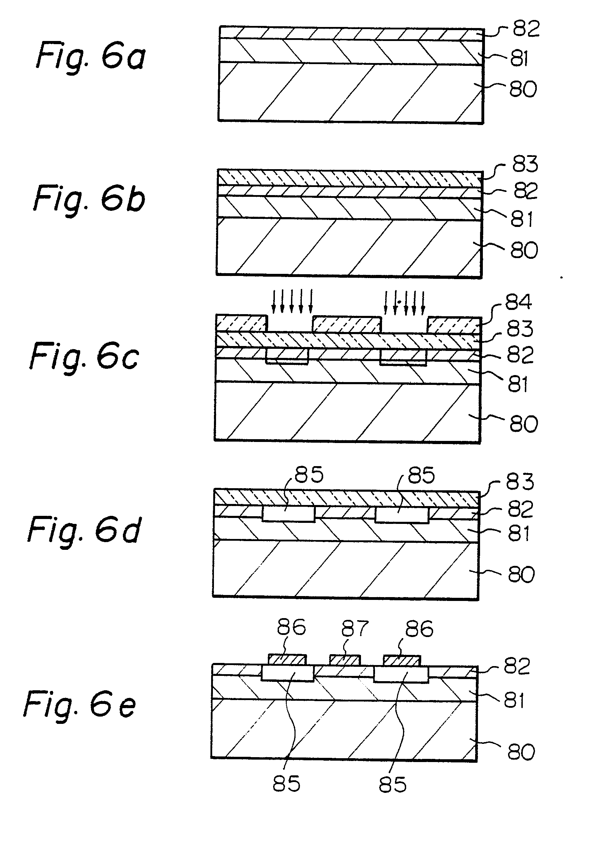

Referring to Fig. 1 and Fig. 6a, a wafer 48, i.e., a semi-insulating GaAs substrate 80, is fixed to the holder 25, and the chamber 20 for MBE is evacuated to, e.g., $10^{-10}$ Torr. Onto the substrate 80, a nondoped GaAs layer 81 of 1 μm thickness and an n-type AlGaAs layer 82 of $1 \times 10^{18}$cm$^{-3}$ Si dosage and 100 nm thickness are formed by MBE. An electron accumulating layer is spontaneously formed in the nondoped GaAs layer 81 near the interface to the n-type AlGaAs layer 82.

Referring to Fig. 1 and Fig. 6b, the wafer 48 is transported to the sputtering chamber 30 and fixed to the holder 36, the chamber 30 being evacuated to, e.g., $10^{-10}$ Torr, similar to that of the MBE chamber 20. For example, the electrode 31 has an Al target, and $N_2$ gas and Ar gas are fed into the sputtering chamber 30 from the gas sources. A high frequency power of 13.56 MHz and 500 W is applied between the electrodes 31 and 32. Thus, reactive sputtering is effected to form an aluminum nitride (AlN) layer 83 of, e.g., 100 to 300 nm on the surface of the n-type AlGaAs layer 82. Selectively, the protective layer may be, for example, of $SiO_2$ or $Si_3N_4$. The wafer is removed from the apparatus in Fig. 1.

Referring to Fig. 6c, a mask 84 is formed by depositing an $SiO_2$ layer and then patterning it. By using the mask 84, Si ions are selectively implanted through the AlN layer 82 into the n-type AlGaAs layer 82 at 100 kV and $1 \times 10^{13}$cm$^{-2}$.

Referring to Fig. 6d, the mask 84 of $SiO_2$ is removed, for example, by hydrofluoric acid. Heat treatment is conducted, e.g., at 750°C for 15 minutes to activate the Si ions, forming n$^+$-type source and drain regions 85 of a carrier concentration of approximately $3 \times 10^{17}$cm$^{-3}$.

Referring to Fig. 6e, the AlN layer 83 is removed by, e.g., heated phosphoric acid. Source and drain electrodes 86 of, e.g., Au·Ge/Au are formed on the n$^+$-type regions 85. A gate electrode 87 is formed of, e.g., Ti/Pt/Au.

In the resultant heterojunction-type FET, the electron accumulating layer has an electron concentration of approximately $5.7 \times 10^{11}$cm$^{-3}$ and an electron mobility of approximately 100,000 cm$^2$/V·sec. In a corresponding prior FET, the electron accumulating layer had an electron concentration of approximately $6.1 \times 10^{11}$cm$^{-2}$ and an electron mobility of approximately 70,000 cm$^2$/V·sec. In such a FET, a protective layer of AlN is formed after the wafer is removed from an MBE apparatus. The original electron concentration and electron mobility of the electron accumulating layer just after MBE are approximately $5.6 \times 10^{11}$cm$^{-3}$ and approximately 110,000 cm$^2$/V·sec, respectively. It is clear that the deterioration of the electron accumulating layer can be decreased in embodiments of the invention.

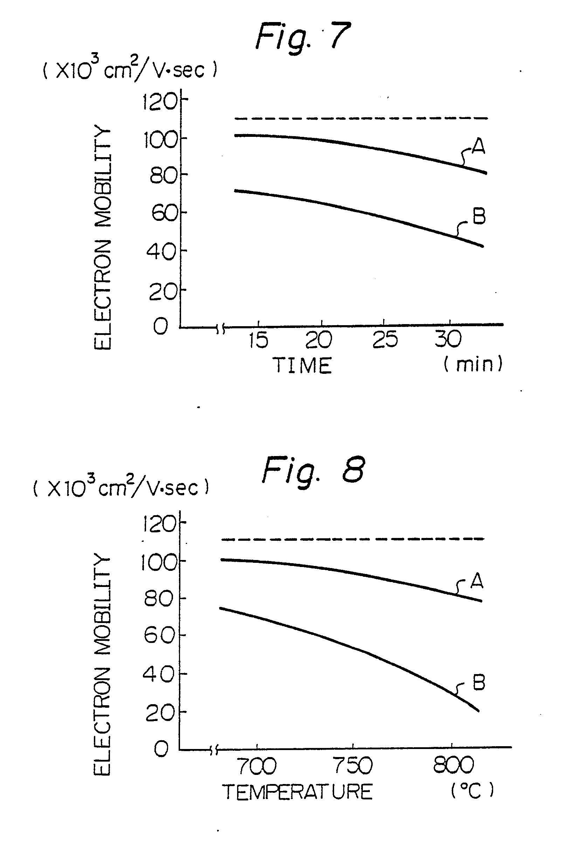

The effects of conditions of heat treatment on electron mobility of heterojunction-type FET's fabricated according to a procedure similar to the above were studied. First, the heat treatment was conducted at approximately 700°C for various time periods. The results are summarized in Fig. 7, in which line A denotes FET's made using methods embodying the invention and line B those of prior methods. Second, the heat treatment was conducted for 15 minutes at various temperatures. The results are summarized in Figs. 8 and 9, in which lines A and B correspond to the FET's of line A and line B in Fig. 7 respectively.

From these results, the present inventors found that, for all times and temperatures of heat treatment, the decline of the electron mobility in a heterojunction-type FET is greatly accelerated by a surface oxide layer formed between the steps of MBE and forming a protective layer and that, therefore, deterioration of electrical characteristics such as electron mobility can be greatly decreased by preventing formation of a surface oxide layer of a semiconductor layer formed by MBE.

While the above explanations concerned heterojunction-type FET's, embodiments of the invention may also be used for other semiconductor devices. It is known that MBE is often used in other semiconductor devices such as semiconductor lasers and photodiodes and that ion implantation is often used for forming, for example, regions of different conduction types in a layer formed by MBE in a semiconductor device.

Since known photodiodes and photolasers have, in general, a thicker cap layer on an active layer than that of a heterojunction-type FET, a surface oxide layer has little effect on the active layer. However, leakage current in a photodiode, etc. is increased by oxidation of the surface of a semiconductor substrate, which can be prevented in embodiments of the present invention. Further, in a reach-through type avalanche photodiode (APD) in which a buried layer of a high impurity concentration is formed in a multiplication layer of the APD, an embodiment of the invention may be applied for a process comprising ion implantation of an impurity into a first epitaxial layer followed by growth of a second epitaxial layer. As a result, deterioration of the APD is decreased due to the prevention of formation of an oxide layer at the interface of the first and second epitaxial layers.

According to an embodiment of the invention, formation of a surface oxide layer at the surface of a grown crystal layer is prevented, resulting in decreased diffusion of an impurity in the crystal layers during subsequent heat treatment in a process for fabricating a semiconductor device.

**Claims**

1. A method of manufacturing a semiconductor device comprising the steps of subjecting a part of a semiconductor substrate to a hydrogen plasma etching process and then forming a semiconductor layer on the substrate in a vacuum by a molecular beam epitaxy process, wherein the substrate is maintained under vacuum without any break thereof between the etching and epitaxy processes.

2. A method as claimed in claim 1, wherein the etching process is employed to clean the surface of the substrate.

3. A method as claimed in claim 1, wherein the etching process is employed to form a recess or hole in the substrate.

4. A method as claimed in any preceding claim, wherein the semiconductor layer consists of a compound semiconductor.

5. A method as claimed in any preceding claim, wherein the semiconductor layer consists of GaAs.

6. A method as claimed in any preceding claim, wherein at least part of the substrate consists of a compound semiconductor.

7. A method as claimed in any preceding claim, wherein at least part of the substrate consists of AlGaAs.

8. A method as claimed in any preceding claim, comprising the further step of subjecting the semiconductor layer in a vacuum to a coating process which causes a protective layer to be formed thereon, wherein the substrate is also maintained under vacuum without any break thereof between the epitaxy and coating processes.

9. A method as claimed in claim 8 which comprises the steps of subjecting a semiconductor substrate to a vacuum and then transporting it to successive stations where it is subjected under vacuum to a hydrogen plasma etch process, to a molecular beam epitaxy process to form a semiconductor layer on the substrate, and then to a process which causes a protective layer to be formed on the semiconductor layer, all without breaking the vacuum.

10. A method as claimed in claim 8 or claim 9, wherein after the formation of the protective layer the semiconductor layer and the protective layer are together subjected to heat treatment.

11. A method as claimed in any one of claims 8 to 10, wherein the protective layer is an insulating layer.

12. A method as claimed in any one of claims 8 to 11, wherein the protective layer consists of AlN, $SiO_2$ or $Si_3N_4$.

13. A method as claimed in any one of claims 8 to 12, wherein the protective layer is formed by sputtering or by a chemical vapour deposition (CVD) process.

14. Apparatus for use in manufacturing a semiconductor device; comprising:

a first vacuum chamber (10) containing means whereby a semiconductor substrate (48) can be subjected to a hydrogen plasma etching process;

a second vacuum chamber (20) containing means whereby such substrate can be subjected to a molecular beam epitaxy process to form a semiconductor layer on such substrate;

vacuum pump means (VP) for establishing a vacuum in each vacuum chamber; and

transfer means (40) defining a vacuum-tight passageway, between the two vacuum chambers, and including conveying apparatus, whereby such semiconductor substrate can be moved from the said first vacuum chamber to the said second vacuum chamber whilst being maintained continuously under vacuum.

15. Apparatus as claimed in claim 14, wherein the hydrogen plasma etching means comprise parallel plate electrode type apparatus (11, 12, 13).

16. Apparatus as claimed in claim 14 or claim 15, further comprising a hydrogen source (14) connected for supplying hydrogen gas to the said first vacuum chamber.

17. Apparatus as claimed in any one of claims 14 to 16, further comprising a third vacuum chamber (30) containing means whereby such substrate can be subjected to a process for forming a protective layer on the semiconductor layer formed by such epitaxy process; wherein vacuum pump means (VP) is arranged to establish a vacuum in each vacuum chamber and the transfer means (40) defines a vacuum-tight passageway between the three vacuum chambers and includes carrying apparatus whereby the semiconductor substrate can be moved between the vacuum chambers whilst being maintained continuously under vacuum.

18. Apparatus as claimed in claim 17, wherein the protective layer forming means comprise sputtering apparatus.

19. Apparatus as claimed in claim 17, wherein the protective layer forming means comprise chemical vapour deposition (CVD) apparatus.

20. Apparatus as claimed in any one of claims 17 to 19, further comprising a gas supply (34) connected for supplying a working gas to the said third vacuum chamber.

21. Apparatus as claimed in any one of claims 14 to 20, wherein the said transfer means are connected to each vacuum chamber by way of a valve.

22. Apparatus as claimed in any one of claims 14 to 21, wherein the vacuum pump means comprise an ion pump or a cryo pump.

23. Apparatus as claimed in any one of claims 14 to 22, wherein the vacuum pump means comprise individual vacuum pumps (15, 24, 35) connected respectively to the vacuum chambers.

**Patentansprüche**

1. Verfahren zur Herstellung einer Halbleitervorrichtung, welches die Schritte umfaßt, einen Teil des Halbleitersubstrats einem Wasserstoffplasmaätzverfahren zu unterwerfen und dann eine Halbleiterschicht auf dem Substrat in einem Vakuum durch ein Molekularstrahl-epitaxieverfahren zu bilden, bei dem das Substrat unter Vakuum gehalten wird, ohne irgendeine Unterbrechung desselben zwischen den Ätz- und Epitaxieverfahren.

2. Verfahren nach Anspruch 1, bei dem der Ätzprozeß dazu verwendet wird, die Oberfläche des Substrats zu reinigen.

3. Verfahren nach Anspruch 1, bei dem der Ätzprozeß dazu verwendet wird, eine Ausnehmung oder ein Loch in dem Substrat zu bilden.

4. Verfahren nach einem der vorhergehenden Ansprüche, bei dem die Halbleiterschicht aus einem Verbindungshalbleiter besteht.

5. Verfahren nach einem der vorhergehenden Ansprüche, bei dem die Halbleiterschicht aus GaAs besteht.

6. Verfahren nach einem der vorhergehenden Ansprüche, bei dem wenigstens ein Teil des Substrats aus einem Verbindungshalbleiter besteht.

7. Verfahren nach einem der vorhergehenden Ansprüche, bei dem wenigstens ein Teil des Substrats aus AlGaAs besteht.

8. Verfahren nach einem der vorhergehenden Ansprüche, welches ferner einen Schritt umfaßt, die Halbleiterschicht in einem Vakuum einem Beschichtungsprozeß zu unterwerfen, der bewirkt, daß eine Shutzschicht darauf gebildet wird, wobei das Substrat ebenfalls unter Vakuum gehalten wird, ohne irgendeine Unterbrechung desselben zwischen den Epitaxie- und Überzugsprozessen.

9. Verfahren nach Anspruch 8, welches die Schritte umfaßt, ein Halbleitersubstrat einem Vakuum zu unterwerfen und es dann zu aufeinanderfolgenden Stationen zu transportieren, wo es unter Vakuum einem Wasserstoffplasmaätzprozeß unterworfen wird, einem Molekularstrahlepitaxieprozeß, um eine Halbleiterschicht auf dem Substrat zu bilden, und dann einem Prozeß, der bewirkt, daß eine Schutzschicht auf der Halbleiterschicht gebildet wird, alles ohne das Vakuum zu unterbrechen.

10. Verfahren nach Anspruch 8 oder 9, bei dem nach Bildung der Shutzschicht die Halbleiterschicht und die Schutzschicht zusammen einer Wärmebehandlung unterworfen werden.

11. Verfahren nach einem der Ansprüche 8 bis 10, bei dem die Schutzschicht eine isolierende Schicht ist.

12. Verfahren nach einem der Ansprüche 8 bis 11, bei dem die Schutzschicht aus AlN, $SiO_2$ oder $Si_3N_4$ besteht.

13. Verfahren nach einem der Ansprüche 8 bis 12, bei dem die Schutzschicht durch Zerstäuben oder durch einen chemischen Dampfabscheidungsprozeß (CVD) gebildet wird.

14. Vorrichtung zur Verwendung bei der Herstellung einer Halbleitervorrichtung, mit: einer ersten Vakuumkammer (10), die Einrichtungen enthält, durch die ein Halbleitersubstrat (48) einem Wasserstoffplasmaätzprozeß unterworfen werden kann; einer zweiten Vakuumkammer (20), die Einrichtungen enthält, durch die solch ein Substrat einem Molekularstrahlepitaxieprozeß unterworfen werden kann, um eine Halbleiterschicht auf solch einem Substrat zu bilden; Vakuumpumpeneinrichtungen (VP) zur Herstellung eines Vakuums in jeder Vakuumkammer; und Transfereinrichtungen (40), die einen vakuumdichten Durchgang zwischen den beiden Vakuumkammern bilden und eine Transportvorrichtung unfassen, durch die solch ein Halbleitersubstrat von der genannten ersten Vakuumkammer zu der genannten zweiten Vakuumkammer bewegt werden kann, während es kontinuierlich unter Vakuum gehalten wird.

15. Verfahren nach Anspruch 14, bei dem die Wasserstoffplasmaätzeinrichtung eine Einrichtung vom Typ mit parallelen Plattenelektroden (11, 12, 13) umfaßt.

16. Vorrichtung nach Anspruch 14 oder 15, ferner mit einer Wasserstoffquelle (14), die zur Zuführung von Wasserstoffgas zu der ersten Vakuumkammer angeschlossen ist.

17. Vorrichtung nach einem der Ansprüche 14 bis 16, ferner mit einer dritten Vakuumkammer (30), die Einrichtungen enthält, durch welche solch ein Substrat einem Prozeß zur Bildung einer Schutzschicht auf der Halbleiterschicht, die durch solch einen Epitaxieprozeß gebildet ist, unterworfen werden kann; bei welcher eine Vakuumpumpeneinrichtung (VP) angeordnet ist, um ein Vakuum in jeder Vakuumkammer zu erzeugen, und die Transfereinrichtung (40) einen vakuumdichten Durchgang zwischen den drei Vakuumkammern begrenzt und eine Tragvorrichtung enthält, durch welche das Halbleitersubstrat zwischen den Vakuumkammern bewegt werden kann, während es kontinuierlich unter Vakuum gehalten wird.

18. Vorrichtung nach Anspruch 17, bei welcher die Einrichtung zur Bildung einer Schutzschicht einen Zerstäubungsapparat umfaßt.

19. Vorrichtung nach Anspruch 17, bei der die Einrichtung zur Bildung der Schutzschicht einen chemischen Dampfabscheidungsapparat (CVD) umfaßt.

20. Vorrichtung nach einem der Ansprüche 17 bis 19, ferner mit einer Gasversorgung (34), die angeschlossen ist, um ein Arbeitsgas zu der genannten dritten Vakuumkammer zu führen.

21. Vorrichtung nach einem der Ansprüche 14 bis 20, bei welcher die genannte Transfereinrichtung mit jeder Vakuumkammer mittels eines Ventils verbunden ist.

22. Vorrichtung nach einem der Ansprüche 14 bis 21, bei der die Vakuumpumpeneinrichtungen eine Ionenpumpe oder eine Cryopumpe umfassen.

23. Vorrichtung nach einem der Ansprüche 14 bis 22, bei der die Vakuumpumpeneinrichtungen individuelle Vakuumpumpen (15, 24, 35) umfassen, die jeweils mit den Vakuumkammern verbunden sind.

**Revendications**

1. Procédé de fabrication d'un dispositif semiconducteur, comprenant les opérations consistant à soumettre une partie d'un substrat semiconducteur à un processus d'incision par plasma d'hydrogène, puis à former une couche semiconductrice sur le substrat, sous vide, à l'aide d'un processus d'épitaxie par faisceau moléculaire, où le substrat est maintenu sous vide sans aucune interruption entre les processus d'incision et d'épitaxie.

2. Procédé selon la revendication 1, où le processus d'incision est utilisé pour nettoyer la surface du substrat.

3. Procédé selon la revendication 1, où le processus d'incision est utilisé pour former un évidement ou un trou dans le substrat.

4. Procédé selon l'une quelconque des revendications précédentes, où la couche semiconductrice est constituée d'un semiconducteur composé.

5. Procédé selon l'une quelconque des revendications précédentes, où la couche semiconductrice est constituée de GaAs.

6. Procédé selon l'une quelconque des revendications précédentes, où au moins une partie du substrat est constituée d'un semiconducteur composé.

7. Procédé selon l'une quelconque des revendications précédentes, où au moins partie du substrat est constituée de AlGaAs.

8. Procédé selon l'une quelconque des revendications précédentes, comprenant l'opération supplémentaire qui consiste à soumettre la couche semiconductrice, sous vide, à un processus de dépôt qui amène la formation d'une couche protectrice sur celle-ci, où le substrat est également maintenu sous vide sans aucune interruption entre les processus d'épitaxie et de dépôt.

9. Procédé selon la revendication 8, qui comprend les opérations consistant à soumettre un substrat semiconducteur à un certain vide, puis à le transporter jusqu'à des postes successifs, où il est soumis, sous vide, à un processus d'incision par plasma d'hydrogène, à un processus d'epitaxie par faisceau moléculaire visant à former une couche semiconductrice sur le substrat, puis à un processus qui amène la formation d'une couche protectrice sur la couche semiconductrice, tout cela sans interrompre l'application du vide.

10. Procédé selon la revendication 8 ou 9, où, après la formation de la couche protectrice, on soumet ensemble à un traitement thermique la couche semiconductrice et la couche protectrice.

11. Procédé selon l'une quelconque des revendications 8 à 10, où la couche protectrice est une couche isolante.

12. Procédé selon l'une quelconque des revendications 8 à 11, où la couche protectrice est constituée de AlN, $SiO_2$ ou $Si_3N_4$.

13. Procédé selon l'une quelconque des revendications 8 à 12, où la couche protectrice est formées par pulvérisation ou par dépôt chimique sous forme vapeur (CVD).

14. Appareil destiné à être utilisé pour la fabrication d'un dispositif semiconducteur, comprenant:

une première chambre à vide (10) contenant des moyens par lesquels un substrat semiconducteur (48) peut être soumis à un processus d'incision par plasma d'hydrogène;

une deuxième chambre à vide (20) contenant des moyens par lesquels ce substrat peut être soumis à un processus d'épitaxie par faisceau moléculaire visant à former une couche semiconductrice sur ce substrat;

une pompe à vide (VP) servant à établir un certain vide dans chaque chambre à vide; et

un moyen de transfert (40) définissant un passage hermétiquement fermé et maintenu sous vide, entre les deux chambres à vide, et comportant un appareil de transport, si bien que ledit substrat semiconducteur peut être déplacé de ladite première chambre à vide à ladite deuxième chambre à vide tout en étant maintenu continûment sous vide.

15. Appareil selon la revendication 14, où le moyen d'incision par plasma d'hydrogène comprend un appareil (11, 12, 13) du type à électrodes en plaques parallèles.

16. Appareil selon la revendication 14 ou 15, comprenant en outre une source d'hydrogène (14) connectée de façon à délivrer de l'hydrogène gazeux à ladite première chambre à vide.

17. Appareil selon l'une quelconque des revendications 14 à 16, comprenant en outre une troisième chambre à vide (30) contenant des moyens par lesquels le substrat peut être soumis à un processus de formation d'une couche protectrice sur la couche semiconductrice formée par le processus d'épitaxie; où la pompe à vide (VP) est destinée à établir un vide dans chaque chambre à vide et le moyen de transfert (40) définit un passage hermétique sous vide entre les trois chambres et comporte un appareil de transport tel que le substrat semiconducteur peut être déplacé entre les chambres à vide tout en étant maintenu continûment sous vide.

18. Appareil selon le revendication 17, où le moyen formant la couche protectrice comprend un appareil de pulvérisation.

19. Appareil selon la revendication 17, où le moyen de formation de couche protectrice comprend un appareil de dépôt chimique sous forme vapeur (CVD).

20. Appareil selon l'une quelconque des revendications 17 à 19, comprenant en outre une alimentation en gaz (34) raccordée de façon à délivrer un gaz de travail à ladite troisième chambre de vide.

21. Appareil selon l'une quelconque des revendications 14 à 20, où ledit moyen de transfert est raccordé à chaque chambre de vide par l'intermédiaire d'une vanne.

22. Appareil selon l'une quelconque des revendications 14 à 21, où la pompe à vide comprend une pompe ionique ou une pompe cryo.

23. Appareil selon l'une quelconque des revendications 14 à 22, où la pompe à vide comprend des pompes à vide distinctes (15, 24, 35) respectivement raccordées aux chambres à vide.

# Fig. I

*Fig. 2*

48

49

*Fig. 3a*

55        55

54
53
52
51

*Fig. 3b*

56        56

54
53
52
51

*Fig. 3c*

58   57   58   57   58

54
53
52
51

*Fig. 3d*

*Fig. 3e*

*Fig. 3f*

# Fig. 4

# Fig. 9

$(\times 10^{11} cm^{-3})$

CONCENTRATION OF ELECTRON IN ELECTRON ACCUMULATING LAYER

TEMPERATURE (°C)

## Fig. 5a

### H₂ PLASMA ETCHING

## Fig. 5b

*Fig. 6a*

*Fig. 6b*

*Fig. 6c*

*Fig. 6d*

*Fig. 6 e*

# Fig. 7

# Fig. 8